**Europäisches Patentamt**

**European Patent Office**

**Office européen des brevets**

(19)

(11) Veröffentlichungsnummer: **0 682 279 A1**

(12) **EUROPÄISCHE PATENTANMELDUNG**

(21) Anmeldenummer: **95105967.4**

(22) Anmeldetag: **21.04.95**

(51) Int. Cl.⁶: **G02B 6/42**

(30) Priorität: **11.05.94 DE 4416563**

(43) Veröffentlichungstag der Anmeldung:
**15.11.95 Patentblatt 95/46**

(84) Benannte Vertragsstaaten:
**DE FR GB IT SE**

(71) Anmelder: **ANT Nachrichtentechnik GmbH**
**Gerberstrasse 33**
**D-71522 Backnang (DE)**

(72) Erfinder: **Kuke, Albrecht, Dr.**
**Nelkenweg 2**
**D-71549 Auenwald (DE)**
Erfinder: **Hauer, Heiner**
**Frühlingshalde 1**
**D-70734 Fellbach (DE)**

(54) **Anordnung zur Ankopplung von optoelektronischen Komponenten und Lichtwellenleitern aneinander.**

(57) Die Erfindung betrifft eine Anordnung zur Ankopplung von optoelektronischen Komponenten und Lichtwellenleitern aneinander mit einem Trägersubstrat (11). Zumindest eine optoelektronische Komponente (9) oder ein Lichtwellenleiter (1) ist auf dem Trägersubstrat (11) befestigt. Mindestens eine Linse (8) ist vorgesehen, die eine im Wesentlichen plane Fläche und eine dieser gegenüberliegende sphärische Fläche aufweist. Diese halbkugelförmige Linse (8) ist in eine Vertiefung (5) im Trägersubstrat (11) derart eingebracht, daß die Linse (8) an zumindest 3 Stellen mit der sphärischen Fläche an den Wandungen der Vertiefung (5) anliegt. Sie ist drehbar.

Fig. 1

EP 0 682 279 A1

Die Erfindung betrifft eine Anordnung zur Ankopplung von optoelektronischen Komponenten und Lichtwellenleitern aneinander mit einem Trägersubstrat, wobei zumindest eine optoelektronische Komponente oder ein Lichtwellenleiter auf dem Trägersubstrat befestigt ist und mindestens eine Linse vorgesehen ist, die eine im Wesentlichen plane Fläche und eine dieser gegenüberliegenden sphärische Fläche aufweist.

Aus der DE 35 43 558 A1 ist eine opto-elektronische Koppelanordnung bekannt, bei welcher das in einem Lichtwellenleiter ankommende Licht auf einen Photodetektor gekoppelt wird. Lichtwellenleiter und Photodetektor sind an einem Trägersubstrat befestigt. Die Kopplung erfolgt über ein optisches Umlenkbauelement. Die Vertiefungen zur Halterung der optischen Komponenten können beispielsweise durch anisotropes Ätzen hergestellt sein. Wenn das aus dem Lichtwellenleiter austretende Licht eine große Winkeldivergenz besitzt läßt sich eine verlustarme Kopplung an den Photodetektor durch eine Linse erreichen. In obiger Schrift wird vorgeschlagen, zwischen dem Lichtwellenleiter und der Photodiode eine Halbkugellinse anzuordnen, deren plane Fläche als Umlenkbauelement ausgebildet ist und die gleichzeitig zur Fokussierung dient.

Zur Strahlfokussierung ist es auch bekannt Fresnellinsen oder Kugellinsen einzusetzen. Die Herstellung von Fresnellinsen auf einem Trägersubstrat, beispielsweise einer Siliziumoberfläche erfordert erhöhten Aufwand mit zusätzlichen Prozeßschritten. Fresnellinsen haben aber den Vorteil einer flachen Bauweise. Kugellinsen können in anisotrop geätzte Vertiefungen, die bei der ohnehin erforderlichen mikromechanischen Strukturierung des Trägermaterials erzeugt werden, eingelegt werden. Sie haben den Nachteil, daß sie entweder über die Substratfläche hinausragen oder im Verhältnis zur optisch wirksamen Fläche sehr große Vertiefungen zur Aufnahme benötigen, wodurch die Montagemöglichkeit der Photodiode beeinträchtigt wird.

Während bei einer Lichtwellenleiter-Photodioden-Ankopplung wegen der verhältnismäßig großen Toleranzen eine rein passive Justage mit Haltestrukturen aus anisotropgeätztem Silizium möglich ist, ist bei der Ankopplung eines Lichtwellenleiters an einen Laser eine ausreichend hohe Genauigkeit durch eine passive Justage mit der anisotropen Ätztechnik nicht zu erreichen. Zur Erzielung einer Kopplung zwischen Laser und Lichtwellenleiter mit einem hohen Einkoppelwirkungsgrad ist wegen der unterschiedlich großen Modenfelddurchmesser eine Abbildungsoptik erforderlich. Eine Justage zwischen Lichtwellenleiter und Laser sollte möglich sein.

Es ist Aufgabe der Erfindung eine Anordnung zur Ankopplung von optoelektronischen Komponenten und Lichtwellenleitern aneinander anzugeben, die einfach aufgebaut ist und eine Justagemöglichkeit einräumt.

Die Aufgabe wird durch eine Anordnung mit den Merkmalen des Patentanspruches 1 oder 2 gelöst. Vorteilhafte Weiterbildungen sind in den Unteransprüchen angegeben.

Durch den Einsatz einer Linse mit einer im wesentlichen planen Fläche und mit einer dieser gegenüberliegenden sphärischen Fläche wird eine Möglichkeit angegeben, Lichtbündel gleichzeitig zu formen und auszurichten. Die beschriebene Linse kann beispielsweise kugelkappenförmig oder halbkugelförmig ausgebildet sein. Eine sphärische oder zylindrische Krümmung der im wesentlichen planaren Fläche, mit einem im Verhältnis zu dem der sphärischen Fläche sehr großen Krümmungsradius ist möglich. Mit der sphärischen Seite liegt die Linse in einer beispielsweise anisotrop geätzten Vertiefung des Trägersubstrats. In dieser Vertiefung ist die Linse um den Krümmungsmittelpunkt der sphärischen Fläche drehbar gelagert. Sie kann zunächst justiert und dann fixiert werden. Die beschriebene Linse läßt sich in verschiedenen Anwendungsfällen einsetzen: beispielsweise zur Fokussierung eines aus einem Lichtwellenleiter austretenden Strahlbündels in die aktive Fläche einer Photodiode, oder zur Verteilung optischer Signalpfade von einem Lichtemissionsboard in ein Lichtempfangsboard. Die Sendeelemente im Lichtemissionsboard können dabei entweder Halbleiterlaser oder optische Wellenleiter sein. Die Empfangselemente im optischen Lichtempfangsboard können dabei entweder Lichtwellenleiter oder Empfangsdioden sein. Dabei wird eine Richtmöglichkeit eines die Linse durchstrahlenden Lichtbündels durch Refraktion ausgenutzt. Ein weiterer Einsatzfall ist zwischen zu verkoppelnden Halbleiterlasern und Lichtwellenleitern wobei dort durch gezielte Verkippung der Halbkugellinse relativ zum Substrat eine Justagemöglichkeit gegeben ist.

Ausführungsbeispiele zu den verschiedenen Anwendungsfällen werden anhand der Zeichnungen erläutert. Es zeigen:

Figur 1 einen Querschnitt durch ein Substrat auf dessen einer Seite ein Lichtwellenleiter und auf dessen anderer Seite eine Photodiode angebracht ist,

Figur 2 die Lage der Linse in der Vertiefung mit entsprechend eingezeichneten Neigungswinkeln,

Figur 3 ein Beispiel für die Lage der Linse in einer Vertiefung wenn Licht an der planen Oberfläche der Linse reflektiert wird,

Figur 4 den Aufbau zur Verteilung optischer Signalpfade zwischen einem Lichtemissionsboard und einem Lichtempfangsboard und

Figur 5 die Kopplung zwischen einem Laser und einem Lichtwellenleiter.

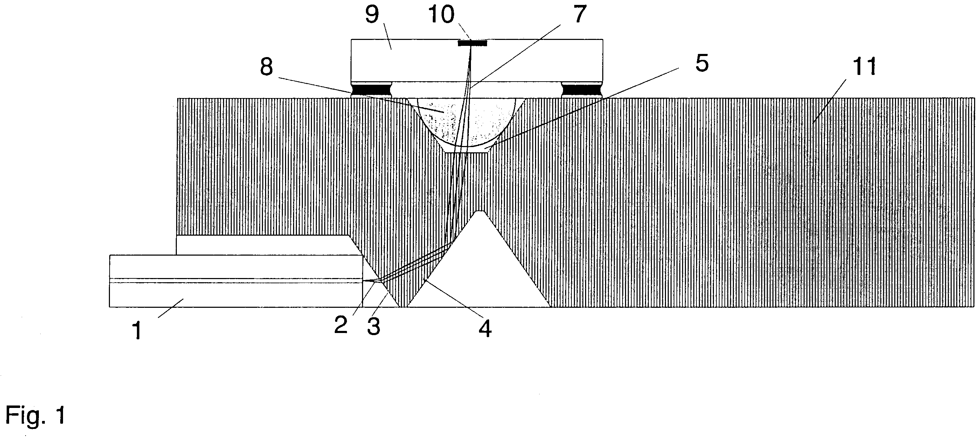

In Figur 1 ist ein Ausführungsbeispiel einer erfindungsgemäßen Anordnung dargestellt. Ein aus einer Faser 1 austretendes gaußsches Strahlbündel 2 wird nach Refraktion an einer geätzten Fläche 4 unter einem Winkel von 6,8° zur Wafernormalen schräg nach oben gelenkt. Auf der Substratoberseite trifft der Strahl auf eine anisotrop geätzte Vertiefung 5 mit einer ebenen Grundfläche 6, in welche eine Halbkugellinse 8 eingelegt und fixiert ist. Die Halbkugellinse bündelt das bis dahin divergente Lichtbündel 2 zu einem konvergenten Lichtbündel 7 in eine Photodiode 9. Die Halbkugellinse ist in ihrem Radius und Brechungsindex so ausgelegt, daß der Bildpunkt des konvergenten Strahls gerade in die aktive Zone 10 der Photodiode 9 fällt. Da entsprechend der Anordnung in Figur 1 für die Abbildung des Faserkerns auf die aktive Fläche der Photodiode die Bildweite kleiner als die Gegenstandsweite ist, ist der Durchmesser des Bildflekkes auch kleiner als der Durchmesser des Faserkerns. Auch unter Berücksichtigung der asphärischen Verzerrung der Halbkugellinse ist der Fleckdurchmesser bei dieser Abbildung kleiner als 10 μm. Deshalb ist auch bei Verwendung von sehr kleinflächigen Photodioden mit einer aktiven Fläche von 30 μm noch eine laterale Montagetoleranz von 10 μm in jeder Richtung zulässig.

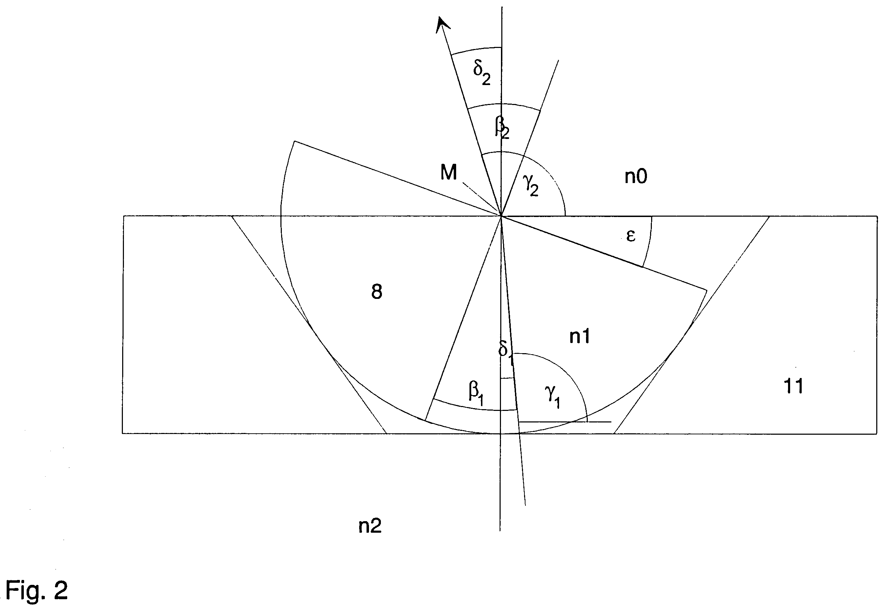

Eine weitere vorteilhafte Eigenschaft der Halbkugellinse besteht in der Möglichkeit, nicht nur einen divergenten Strahl zu fokussieren oder zu kollimieren, sondern auch in seiner Richtung einzustellen. Die geometrische Überlegung hierzu ist in Figur 2 erläutert. Ein Lichtbündel, repräsentiert durch seinen Mittelstrahl 21, trifft auf die sphärische Seite einer Halbkugellinse 8, wobei der Mittelstrahl erfindungsgemäß so ausgerichtet ist, daß er durch den Kugelmittelpunkt M verläuft. Die Halbkugellinse ist in einer Vertiefung 5 einer Trägerplatte 11 gelagert, wobei die sphärische Fläche der Halbkugel auf den Seitenwänden der Vertiefung aufliegt. Durch diese Art der Lagerung kann die Halbkugellinse in zwei Raumrichtungen verkippt werden, wobei der Kugelmittelpunkt M ortsfest bezüglich der Trägerplatte 11 und dem einfallenden Strahlbündel 21 bleibt. Die Lichtbrechung an der sphärischen Fläche der Halbkugellinse wird bei der Verkippung daher nicht verändert. Wenn die Strahltaille des einfallenden Lichtbündels in der Brennfläche der Halbkugellinse liegt, so ist innerhalb der Halbkugellinse das Lichtbündel kollimiert. Die Brennfläche Bf wird durch eine Halbkugelschale um den Kugelmittelpunkt M gebildet, die den Radius $r_f$ besitzt. Der Brennradius $r_f$ berechnet sich für mittelpunktsnahe Strahlen zu

$$r_f = n_1 * r / (n_1 - n_0) \qquad (1)$$

wobei $n_1$ der Brechungsindex und r der Radius der Halbkugel und $n_0$ der Brechungsindex im Außenraum ist.

Wenn die Linse in ihrer Kipplage gerade so ausgerichtet ist, daß die Flächennormale ihrer Basisebene parallel zum Mittelstrahl des einfallenden Bündels liegt, so wird das aus der Linse austretende Bündel nicht gebrochen. Bei einer Verkippung der Normalenrichtung gegenüber dem einfallenden Mittelstrahl ergibt sich eine Winkelverkippung des austretenden Bündels durch die Lichtbrechung aufgrund des Snellius'schen Brechungsgesetzes. Ein im Linseninnern paralleles Lichtbündel bleibt dabei parallel. Auf diese Weise ist es möglich, nicht nur einen kollimierten Strahl zu erzeugen, sondern diesen auch innerhalb gewisser Grenzen, die durch den Brechungsindex der Halbkugellinse und den Verstellbereich der Linsenlagerung gegeben sind, beliebig in seiner Strahlrichtung in einem zweidimensionalen Winkelbereich einzustellen.

Für die Berechnung der Strahlrichtungen vor und nach Durchlaufen der Halbkugellinse gelten die im folgenden angegebenen Beziehungen. Dabei werden mit dem Index 1 die Größen innerhalb der Halbkugellinse und mit dem Index 2 die Größen in dem an die Basisebene der Halbkugellinse grenzenden Außenraum bezeichnet. Die Größen im Außenraum, der an die sphärische Halbkugelseite grenzt erhalten den Index 0. Als Richtungswinkel $\gamma$ werden die Winkel zwischen der Substratebene und der Strahlrichtung bezeichnet. Als Einfallswinkel $\beta$ sind die Winkel zwischen der Normalen der Basisfläche der Kugellinse und der Strahlrichtung bezeichnet. Der Winkel $\epsilon$ ist der Kippwinkel der Linse, also der Winkel zwischen den Flächennormalen des Substrates und der Halbkugelbasisfläche. Die Brechungsindizes werden mit n bezeichnet. Man erhält folgende Beziehungen:

$$\beta_1 = \epsilon - \delta_1 \qquad (2)$$
$$\beta_2 = \epsilon - \delta_2 \qquad (3)$$
$$\sin \beta_2 / \sin \beta_1 = n_1 / n_2 \qquad (4)$$
$$\gamma_1 = 90° + \delta_1 \qquad (5)$$
$$\gamma_2 = 90° + \delta_2 \qquad (6)$$
$$\gamma_1 = \gamma_0 \qquad (7)$$

Durch Vorgabe des Kippwinkels $\epsilon$ und eines Richtungswinkels $\gamma_2$ eines eintretenden Strahls läßt sich anhand der Gleichungen (2 - 7) der Richtungswinkel $\gamma_0$ des austretenden Strahls und umgekehrt berechnen. Andererseits läßt sich aus vorgegebenen Richtungswinkeln $\gamma_0$ und $\gamma_2$ der erforderliche Kippwinkel $\epsilon$ berechnen. Die hier angegebenen Gleichungen sind anhand der Figur 2 für einen Strahlverlauf in der Zeichenebene der Figur 2 abgeleitet. Da aber einfallender und gebrochener Strahl stets in einer Ebene, der Einfallsebene, liegen, welche die Flächennormale der Basisebene der Halbkugellinse und die ein- und ausfallenden Strahlen enthält, gelten die obigen Gleichungen für beliebige Strahlrichtungen auch außerhalb der Zeichenebene von Figur 2, da sich in diesem allgemeinen Fall stets eine Zeichenebene finden läßt, die in der Einfallsebene liegt.

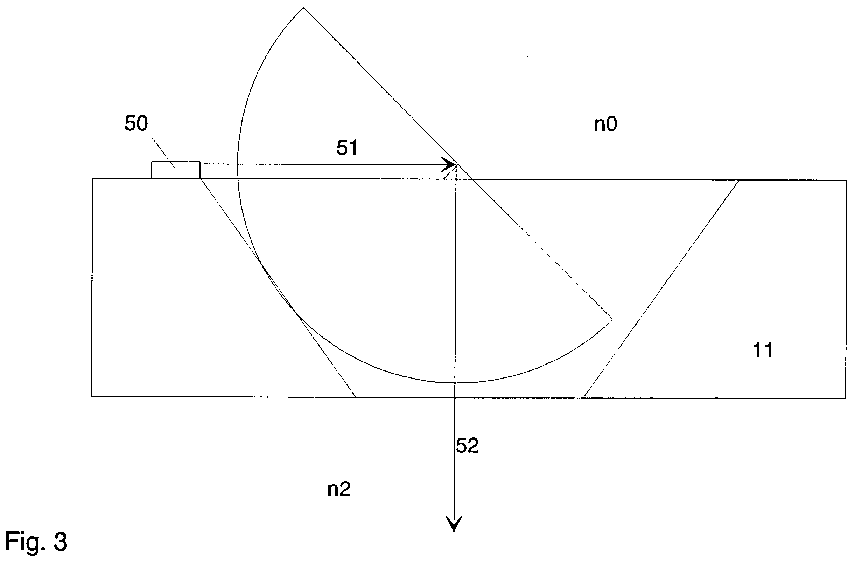

Neben der genannten Richtmöglichkeit eines Lichtbündels durch Refraktion ist durch eine Halbkugellinse auch eine Richtungmöglichkeit durch Reflexion möglich. Zur Erläuterung hierzu sei auf die Figur 3 verwiesen, in welcher ein Anwendungsfall dargestellt ist. Auf einem Träger 11, vorzugsweise ein anisotrop geätztes Siliziumsubstrat, ist ein Halbleiterlaser 50 montiert, wobei das Siliziumsubstrat zugleich als sehr effektive Wärmesenke und als Träger der Leiterbahnstruktur zur Ansteuerung und Kontaktierung des Lasers dient (hier nicht gezeichnet). Vor dem Laser ist eine Vertiefung 5 anisotrop geätzt in welche eine Halbkugellinse eingelegt ist. Die Größe und Lage der Vertiefung bestimmt die Position des Kugelmittelpunktes M der Halbkugellinse. Die Höhe des Kugelmittelpunktes ist so gewählt, daß er in der Höhe der aktiven Zone des Lasers liegt. Ebenso ist die Lage der Vertiefung so gewählt, daß M in der optischen Achse des aus dem Laser austretenden divergenten Strahlbündels 51 zu liegen kommt. Im Unterschied zu Figur 2 ist hier die Basisebene der Halbkugellinse wesentlich stärker gegenüber dem einfallenden Strahl 51 geneigt und sowohl der einfallende Strahl 51 als auch der ausfallende Strahl 52 durchdringen beide die sphärische Seite 81 der Halbkugellinse. Erfindungsgemäß soll der Winkel zwischen der Normalen der Basisfläche und den Strahlen des einfallenden Bündels unter Berücksichtigung der Brechung der Randstrahlen dieses Bündels größer sein als der Grenzwinkel der Totalreflexion, in diesem Fall wird alles Licht an der Basisfläche totalreflektiert. Bei Einfallswinkeln auf die Basisfläche, die kleiner sind als der Grenzwinkel der Totalreflexion soll die Basisfläche ebenfalls erfindungsgemäß mit einer Verspiegelung versehen sein. Der Brennradius $r_f$ verringert sich gegenüber der Berechnung nach Gl. 1 durch die zweimalige Lichtbrechung an der sphärischen Fläche auf die Hälfte.

Für photonische Anwendungen zur Verknüpfung zahlreicher Ein- und Ausgangssignalpfade, wie sie beispielsweise in Vermittlungsnetzwerken oder in neuronalen Netzen benötigt werden, wird nach dem Stand der Technik so verfahren, daß mehrere Ausgangspfade in einer Subschaltebene angelegt werden und dann mehrere Subschaltebenen übereinander angeordnet werden, so daß ein zweidimensionaler räumlich gestaffelter Ausgangskörper vorliegt, in welchem in einer Austrittsebene in einem vorgegebenen zweidimensionalen Rastermaß n•m Lichtausgänge vorliegen. Die aus diesen Lichtausgängen austretenden divergenten Strahlbündel werden in einer davor angebrachten planaren Struktur beispielsweise über Fresnellinsen kollimiert und in einer zweiten unmittelbar dahinter befindlichen zweiten planaren Struktur, beispielsweise durch Hologramme, in vorgewählte Richtungen umgebaute zweidimensionale Umlenkungsstruktur und eine Fokussierungsstruktur vorgesehen, die die Lichtbündel in die Photodioden der jeweiligen Empfangspfade einkoppelt. Die Empfangspfade sind ähnlich wie die Sendepfade wieder in aufeinander gestapelten Subschaltebenen angeordnet. Nachteilig an dieser Anordnung nach dem Stand der Technik ist, daß eine sehr hohe geometrische Präzision in der Anordnung der Subschaltebenen zueinander, der abbildenden und umlenkenden planaren Strukturen zueinander und dieser Strukturen zu den Ein- und Ausgangsstapeln der Subschaltebenen erreicht werden muß.

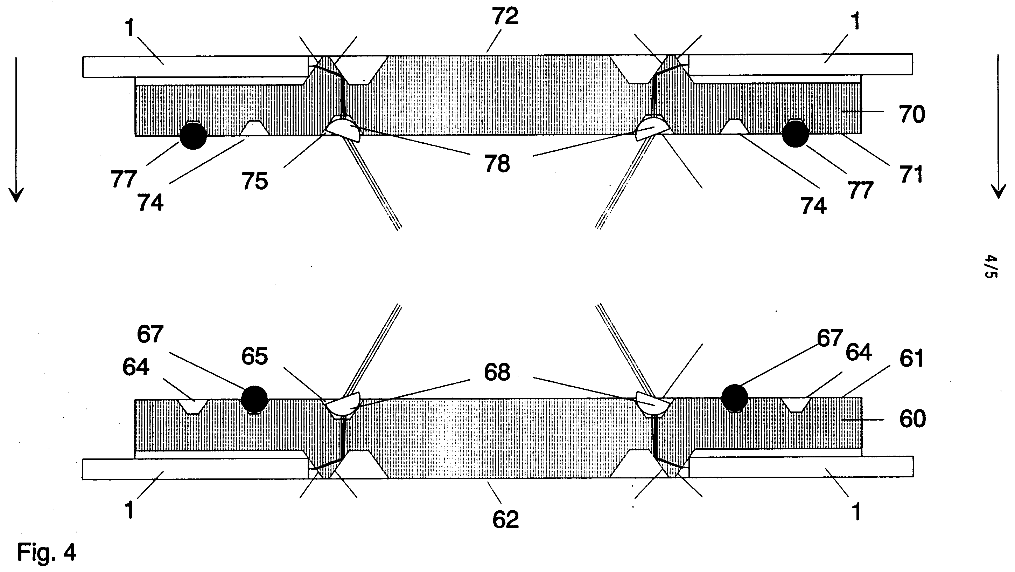

Erfindungsgemäß können die strahlformenden und strahlrichtenden Aufgaben der genannten planaren Strukturen zusammen durch Halbkugellinsen übernommen werden. Ein Ausführungsbeispiel für die erfindungsgemäße Lösung hierfür ist in Figur 4 dargestellt. Ein Lichtemissionsboard 60 enthält in einer zweidimensional periodischen Anordnung auf seiner Oberseite 61 eine Anzahl von n•m Halbkugellinsen 68, die in Vertiefungen 65 sitzen und in der Lage sind, den Strahl zu kollimieren und zu richten. Auf der Unterseite 62 sind entweder Wellenleiter, deren Lichtbündel wie unter Anwendung 1 beschrieben durch Refraktion und/oder Reflexion ungefähr senkrecht zur Substratebene umgelenkt werden. Durch die Ausrichtung der Basisflächen der Halbkugellinsen kann jeder der n•m Lichtbündel individuell gerichtet werden. Statt der Wellenleiter können auch wie in Figur 3 gezeigt Halbleiterlaser auf der Unterseite des Substrates montiert werden, deren Licht wie oben beschrieben kollimiert und gerichtet werden kann. Die Empfangsseite ist entsprechend zur Sendeseite aufgebaut. Ein Empfangsboard 70 enthält auf seiner Unterseite eine Anzahl von n•m Halbkugellinsen 78 in Vertiefungen 75, die die auf sie gerichteten kollimierten Strahlbündel durch die entsprechende Neigung ihrer Basisflächen senkrecht zur Substratebene richten und fokussieren. Auf der Oberseite 72 sind entweder Lichtwellenleiter oder Empfangsdioden angebracht. Gegenüber der Anordnung nach dem Stand der Technik hat die angegebene Lösung folgende Vorteile:

Die Aufgaben der Strahlformung und Strahlausrichtung sind in einem Bauteil, der Halbkugellinse zusammengefaßt. Anstelle von 2•m Subschaltebenen sind nur ein Sende- und ein Empfangsboard erforderlich.

Es müssen nicht 2•m Subschaltebenen und 4 Strahlformungs- bzw. Strahlablenkungsebenen zueinander justiert werden, sondern nur noch ein Empfangsboard zu einem Sendeboard. Die Justage der beiden Boards zueinander kann dabei durch anisotrop geätzte Vertiefungen 64 und 74 und in diese eingelegte Justagekörper 67 rein passiv geschehen. Wenn die Justage-Vertiefungen im gleichen anisotropen Ätzprozeß wie die Vertiefungen 65 bzw. 75 hergestellt werden, so wird eine hohe Genauigkeit der Ausrichtung erzielt.

Die Ausrichtung der Halbkugellinsen läßt sich für alle Linsen gemeinsam mit einer entsprechend geformten Lehre, die während des Fixierprozesses auf die Basisflächen der Linsen aufliegt erreichen. Für andere Pfadverknüpfungen ist nur eine andere Lehre zu verwenden.

Während bei einer LWL-Photodiode-Ankopplung wegen der verhältnismäßig großen Toleranzen (siehe auch Anwendung 1 mit lateralen Toleranten von 10 $\mu$m) eine rein passive Justage mit Haltestrukturen aus anisotrop geätzten Silizium möglich ist, ist bei der Ankopplung eines Lichtwellenleiters an einen Laser eine ausreichend hohe Genauigkeit für eine passive Justage mit der anisotropen Ätztechnik oder auch mit anderen Methoden nach dem Stand der Technik noch nicht und auch in Zukunft wahrscheinlich nur unter sehr großem Aufwand zu erreichen, da der Laser wegen seines geringen Modenfelddurchmessers von ca. 1 $\mu$m eine Lagegenauigkeit im Submikrometerbereich erfordert. Zur Erzielung einer guten Kopplung zwischen Laser und LWL ist wegen der unterschiedlich großen Modenfelddurchmesser eine Abbildungsoptik erforderlich. Nach dem Stand der Technik ist zumindest in den empfindlichen zur Strahlrichtung senkrechten Richtungen eine Justage in der Ebene der Stirnfläche des LWL erforderlich. Hierbei wird üblicherweise eine aktive Flanschjustage des Lichtwellenleiters durchgeführt. Da die Justageebene senkrecht zur Strahlrichtung liegt, muß der planare Aufbau eines Moduls durch eine senkrecht zur Substratebene liegende Flanschebene ergänzt werden, was einen zusätzlichen Montageaufwand bedeutet.

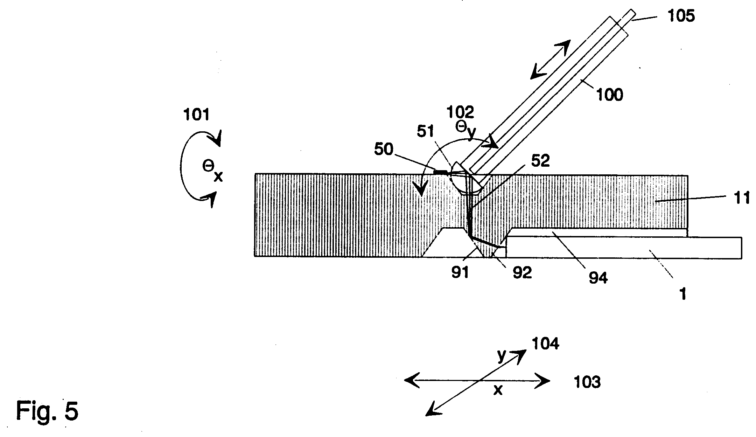

Der Montage- und Justageaufwand läßt sich bedeutend reduzieren, indem eine Anordnung gemäß Figur 5 verwendet wird. Ein Substrat 11 trägt einen direkt darauf montierten Halbleiterlaser 50. Vor dem Halbleiterlaser ist eine Vertiefung 5 geätzt, die eine Halbkugellinse 8 trägt, die entsprechend den Ausführungen zu Figur 3 einen großen Neigungswinkel $\epsilon$ von ca. 45° gegenüber der Substratfläche besitzt. Der von der Halbkugellinse geformte und gerichtete Strahl 51 und 52 wird an den Flächen 91 und 92 totalreflektiert bzw. gebrochen und trifft auf die Stirnfläche eines Lichtwellenleiters 93. Zur Strahlumlenkung kann außer den Flächen 91 und 92 auch jede andere geeignete Strahlumlenkvorrichtung eingesetzt werden, mit deren Hilfe der Strahl aus der nahezu vertikalen Richtung in eine nahezu horizontale Richtung gelenkt werden kann, beispielsweise eine Spiegelfläche. Der Lichtwellenleiter 93 kann entweder eine Lichtleitfaser sein, die in einer anisotrop geätzten V-Nut 94 eingelegt ist oder er kann ein Streifenlichtwellenleiter sein. Durch die anisotrope Strukturierung der Ober- und Unterseite des Substrates mit Markierungen 95 als Positionierhilfen für den Laser und einer Halterung 94 für den Lichtwellenleiter sowie durch die hohe Genauigkeit der durch anisotropes Ätzen dargestellten Strahlumlenkflächen 91 und 92 ist bereits eine Vorpositionierung dieser optischen Komponenten gegeben. Die Genauigkeit reicht aber, wie oben ausgeführt, noch nicht aus. Zur Justage wird nun nicht, wie nach dem Stand der Technik üblich, der Lichtwellenleiter bewegt, bis eine optimale Kopplung erreicht ist, sondern der Lichtwellenleiter bleibt in seiner fixierten Lage ebenso wie der Laser fest liegen. Statt dessen wird erfindungsgemäß das durch die Halbkugellinse erzeugte Bild des Lasers über die Stirnfläche des Lichtwellenleiters solange justiert, bis eine optimale Kopplung erreicht worden ist. Hierzu wird die Winkelausrichtung der Basisfläche der Halbkugellinse relativ zum Substrat bewegt, was wegen der Reflexion des Lichtbündels an der Basisfläche zu einem Schwenken des reflektierten Strahls 52 und damit zu einer Bewegung des Bildpunktes auf der Stirnfläche des LWL führt. Da der einfallende Strahl 51 auf den Kugelmittelpunkt M gerichtet ist, ändert sich während der Justage nur die Strahlrichtung, nicht aber die Abbildungseigenschaften der Linse.

Anstatt die Halbkugellinse gegenüber einem ortsfesten Substrat zu verkippen kann auch die Linse ortsfest gehalten werden und dafür das Substrat verkippt werden. In Figur 5 ist eine erfindungsgemäße Justagevorrichtung dargestellt. Das Substrat 11 sitzt auf einem in den Winkeln $\Theta_x$ und $\Theta_y$ schwenkbaren Goniometertisch 101, 102, dessen Rotationsachsen $R_x$ und $R_y$ sich in einem Punkt $M_R$ rechtwinklig schneiden. Ein auf dem Goniometertisch aufgesetzter XY-Tisch 103, 104 bewegt das Substrat vor der Justage so, daß der Kugelmittelpunkt M der Halbkugellinse 8 in den Rotationsmittelpunkt $M_R$ fällt. Vor der Justage wird der Goniometertisch in die waagerechte Stellung gebracht und die Halbkugellinse mit einem Rohr 100 beispielsweise durch Vakuumansaugung gehalten und mit leichter Kraft in die Vertiefung 5 gedrückt, wobei das Rohr einen Winkel von etwa 45° zur Wafernormalen einschließt. Zur späteren Fixierung kann ein Kleber, vorzugsweise ein mit UV-Licht aushärtbarer Kleber verwendet werden, der schon vor der Fixierung in die Vertiefung 5 eingebracht sein kann. Der Kleber kann durchaus auch den Raum unterhalb der Linse zwischen Linse und Trägermaterial, vorzugsweise Silizium, einnehmen. Zur Berechnung der Linsenbrechkraft (siehe Gl. 1) ist dann entsprechend der Brechungsindex des Klebers einzusetzen. Durch Kippbewegung des Goniometertisches in einem zweidimensionalen Winkelbereich kann nun der Strahl zur Erreichung eines optimalen Koppelwirkungsgrades geschwenkt werden. Mit üblichen Goniometertischen ist eine Winkelauflösung von 0,001° erreichbar. Bei einem Lichtweg s entsprechend der Substratdicke von 500 $\mu$m ergibt ein Schwenkwinkel $\Delta\epsilon$ von 0,001° eine Auslenkung des Bildpunktes $\Delta x$ von

$$\Delta x = 2 \cdot s \cdot \tan(\Delta\epsilon) = 0,017 \, \mu m \qquad (8)$$

Diese Justage ist also mindestens so genau wie herkömmliche laterale Verschiebetische mit einer Genauigkeit von typisch 0,1 $\mu$m. Da die Halbkugellinse mit ihrer sphärischen Fläche während der Justage stets auf den Seitenflächen der Vertiefung 5 aufliegt, ist bei der anschließenden Fixierung keine Dejustierung zu erwarten. Eine Haftreibung, die während der Justage bei der herkömmlichen Flanschmethode leicht zu einer störenden ruckartigen Bewegung führen kann, ist hier nicht zu befürchten, da während der Justage der Kleber flüssig ist und daher eine haftreibungsfreie Flüssigkeitsreibung vorliegt.

Ein weiterer Vorteil des erfindungsgemäßen Justageverfahrens liegt darin, daß sich die Kleber nicht zwischen metallischen Flanschflächen sondern zwischen der optisch transparenten Halbkugellinse und dem Silizium befindet. Aus diesem Grund kann überhaupt nur ein mit Licht aushärtbarer Kleber eingesetzt werden. Das zur Aushärtung benötigte UV-Licht wird durch die Linse hindurch auf den Kleber gestrahlt. Vorzugsweise kann in dem Rohr 100, das zum Festhalten der Linse dient, gleichzeitig ein Lichtwellenleiter 105 für UV-Licht geführt werden. Nach Erreichung der optimalen Justageposition wird das UV-Licht über den im Rohr befindlichen Lichtwellenleiter durch die Basisfläche der Halbkugellinse, die bei senkrechtem Einfall im Gegensatz zu ihrer Totalreflexion für die Strahlen 51, 52 durchlässig ist, hindurch auf die Klebestellen auf der sphärischen Seite der Halbkugellinse gerichtet.

Für eine Automation des Justage- und Fixiervorgangs, auch für Module mit mehreren Lasern auf einem Substrat, kann das Rohr 100 in Verbindung einer axialen Bewegungseinrichtung des Rohrs und den X-Y-Tischen 103, 104 die Halbkugellinsen aus einem Depot durch Vakuumansaugung aufnehmen und an die entsprechenden Vertiefungen 5 bringen.

Üblicherweise haben Halbleiterlaser kein zirkularsymmetrisches Modenfeld wie Lichtleitfasern sonder ein elliptisches Modenfeld. Insbesondere Hochleistungslaser, die zum Pumpen optischer Faserverstärker Verwendung finden haben ein elliptisches Nahfeld mit einem Achsenverhältnis con ca. 3:1. Bei der Abbildung auf das zirkularsymmetrische Feld einer Faser kann dabei mit einer zirkularsymmetrischen Linse keine optimale Ankopplung erreicht werden, die aber gerade in diesem Anwendungsfall von außerordentlicher Wichtigkeit wäre. Neuere Vorschläge zur Lösung dieses Problems sehen eine zylinderförmige Linse vor, die quer vor eine zirkularsymmetrische Linse gelegt wird. Auch wenn dadurch ein besserer Koppelwirkungsgrad erreicht werden kann, so hat man sich doch den Nachteil eines zusätzlich zu justierenden optischen Bauteils eingehandelt.

Durch eine leichte Abwandlung der Halbkugellinse läßt sich auch dieses Problem auf einfache Weise lösen. Hierzu wird die bisher ebene Basisfläche der Halbkugellinse zylindrisch bearbeitet. Dies kann entweder dadurch geschehen, daß die Basisfläche zylindrisch geschliffen und poliert wird oder daß die Basisfläche bei Erwärmung über die Erweichungstemperatur über einen entsprechend geformten Stempel geprägt wird. Dieses Prägeverfahren wird zur Zeit bei der Herstellung asphärischer Linsen angewandt. Durch geeignete Formgebung des Prägewerkzeugs kann die Basisfläche auch so geformt werden, daß neben der zylindrischen Komponente zur Anpassung eines elliptischen Modenfeldes an ein zirkularsymmetrisches Modenfeld zusätzlich eine asphärische Komponente zur Reduzierung bzw. Vermeidung der sphärischen Verzerrungen durch die Kugelflächen erreicht werden kann. Ebenso kann eine zusätzliche Strahlkorrektur bzw. Strahlbeeinflussung dadurch erreicht werden, daß auf der Basisfläche der Linse eine Fresnelstruktur aufgebracht wird. Die Formgebung der Basisfläche hat keinen Einfluß auf die genannten erfindungsgemäßen Justage- und Strahllenkungseigenschaften, die durch die kugelförmige Auflage der Linse 8 auf die Seitenflächen der Vertiefung 5 begründet sind.

**Patentansprüche**

1. Anordnung zur Ankopplung von optoelektronischen Komponenten und Lichtwellenleitern aneinander mit einem Trägersubstrat (11), wobei zumindest eine optoelektronische Komponente (9) oder ein Lichtwellenleiter (1) auf dem Trägersubstrat (11) befestigt ist, und mindestens eine Linse (8) vorgesehen ist, die eine im wesentlichen plane Fläche und eine dieser gegenüberliegende sphärische Fläche aufweist, dadurch gekennzeichnet, daß die Linse (8) in eine Vertiefung (5) im Trägersubstrat (11) derart eingebracht ist, daß die Berührungspunkte von Linse (8) und Wandungen der Vertiefung (5) auf der sphärischen Fläche der Linse (8) liegen und daß die Linse (8) um den Krümmungsmittelpunkt der sphärischen Fläche drehbar gelagert ist.

2. Anordnung zur Ankopplung von optoelektronischen Komponenten und Lichtwellenleitern aneinander mit einem Trägersubstrat (11), wobei zumindest eine optoelektronische Komponente (9) oder ein Lichtwellenleiter (1) auf dem Trägersubstrat (11) befestigt ist, und mindestens eine Linse (8) vorgesehen ist, die eine im Wesentlichen plane Fläche und eine dieser gegenüberliegende sphärische Fläche aufweist, dadurch gekennzeichnet, daß die Linse (8) in eine Vertiefung (5) im Trägersubstrat (11) derart eingebracht ist, daß die Berührungspunkte von Linse (8) und Wandungen der Vertiefung (5) auf der sphärischen Fläche der Linse (8) liegen und daß die Linse (8) eine Ausrichtung eines durch sie hindurchtretenden Lichtbündels mittels Refraktion bewirkt.

3. Anordnung nach Anspruch 2, dadurch gekennzeichnet, daß die Linse (8) in der Vertiefung (5) drehbar gelagert ist.

4. Anordnung nach einem der Ansprüche 1 bis 3, dadurch gekennzeichnet, daß die Linse nach erfolgter Justage mittels eines Klebstoffes fixiert ist.

5. Anordnung nach einem der Ansprüche 1 bis 4, dadurch gekennzeichnet, daß die Linse (8) in einer anistotrop geätzten Vertiefung (5) befestigt ist.

6. Anordnung nach Anspruch 5, dadurch gekennzeichnet, daß zumindest eine optoelektronische Komponente (9) oder ein Lichtwellenleiter (1) in einer anisotrop geätzten Vertiefung im Trägersubstrat (11) befestigt ist.

7. Anordnung nach einem der Ansprüche 1 bis 6, dadurch gekennzeichnet, daß die plane Fläche der Linse (8) derart gegen die Oberfläche des Trägersubstrates (11) geneigt angeordnet ist, daß eine Strahlablenkung resultiert, die an die geometrische Lage der optoelektronischen Komponenten (9) oder Lichtwellenleiter (1) angepaßt ist.

8. Anordnung nach einem der Ansprüche 1 bis 7, dadurch gekennzeichnet, daß die Linse (8) halbkugelförmig ist.

Fig. 1

EP 0 682 279 A1

Fig. 2

EP 0 682 279 A1

EP 0 682 279 A1

50

51

n0

52

n2

11

Fig. 3

Fig. 4

Fig. 5

Europäisches
Patentamt

**EUROPÄISCHER RECHERCHENBERICHT**

Nummer der Anmeldung
EP 95 10 5967

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | EP-A-0 421 118 (SIEMENS AG) 10.April 1991 <br> * Spalte 2, Zeile 2 - Spalte 3, Zeile 27; Abbildung 1 * | 2,4-6 | G02B6/42 |
| A | | 1,8 | |
| A | EP-A-0 362 767 (LASAG AG) 11.April 1990 <br> * Spalte 3, Zeile 58 - Spalte 4, Zeile 23; Abbildungen 4,5 * | 1,3 | |
| A | US-A-4 919 506 (COVEY ROBERT L) 24.April 1990 <br> * Spalte 5, Zeile 57 - Zeile 65; Abbildung 6 * | 1,2,7,8 | |
| A | EP-A-0 331 331 (AT&T) 6.September 1989 <br> * Spalte 8, Zeile 51 - Spalte 9, Zeile 8 * <br> * Spalte 4, Zeile 29 - Zeile 51; Abbildung 9 * | 1,2,5,6 | |
| A,D | DE-A-35 43 558 (LICENTIA GMBH) 11.Juni 1987 <br> * Spalte 2, Zeile 49 - Spalte 3, Zeile 50; Abbildungen 1,6 * | 6-8 | **RECHERCHIERTE SACHGEBIETE (Int.Cl.6)** <br><br> G02B |

Der vorliegende Recherchenbericht wurde für alle Patentansprüche erstellt

| Recherchenort | Abschlußdatum der Recherche | Prüfer |
|---|---|---|
| BERLIN | 17.August 1995 | von Moers, F |